# EUROPEAN PATENT APPLICATION

(11) **EP 4 704 139 A1**
(43) Date of publication of application: **04.03.2026**
(21) Application number: 24197824.6
(22) Date of filing: 02.09.2024
(51) Int. Cl.: H01J 37/32, H03H 7/38

(54) **IMPEDANCE MATCHING NETWORK, IMPEDANCE MATCHING CONTROL SYSTEM AND METHOD OF IMPEDANCE MATCHING**

(71) Applicant: Rohde & Schwarz GmbH & Co. KG, 81671 München (DE)
(72) Inventor: Dueben, Reimo, 81671 München (DE); Andrei, Andreas, 81671 München (DE); Fruehauf, Adrian, 81671 München (DE); Pietzka, Mathias, 81671 München (DE); Ohnimus, Florian, 81671 München (DE); Meixner, Alexander, 81671 München (DE)
(74) Representative: Prinz & Partner mbB

(57) **Abstract**

An impedance matching network (20) for plasma processes is described. The impedance matching network (20) comprises an input port (28) being connectable to a radio frequency, RF, generator module. The impedance matching network (20) further comprises an output port (30) being connectable to a load. The impedance matching network (20) further comprises a transmission circuit (32), wherein the transmission circuit (32) connects the output port (30) to the input port (28). The transmission circuit (32) comprises a first transmission line (34) and a second transmission line (36), wherein the first transmission line (34) is electrically connected to the input port (28), and wherein the second transmission line (36) is electrically connected to the output port (30). The impedance matching network (20) further comprises a first impedance matching module (48), wherein the first impedance matching module (48) is configured to connect at least one reactance to the transmission circuit (32). The impedance matching network (20) further comprises a coupling element (38), wherein the first transmission line (34) and the second transmission line (36) are coupled to each other by the coupling element (38), and wherein the coupling element (38) provides an inductive coupling between the first transmission line (34) and the second transmission line (36). Further, an impedance matching control system, and a method of impedance matching are described.

## Description

The present invention generally relates to an impedance matching network for plasma processes. The present invention further relates to an impedance matching control system, and to a method of impedance matching.

For igniting and maintaining a plasma, usually an RF power generator is connected to a chamber feed unit that transfers the power of the RF signal generated by the RF power generator into a plasma chamber containing the plasma.

As the impedance of the plasma usually differs significantly from commonly used interface impedances (e.g. 50 Ohm), and as the impedance can vary significantly over time and power level, it is common in the state of the art to provide an impedance matching network in order to optimize the efficiency of the power transfer into the plasma.

Due to energy dissipation caused e.g. by ohmic resistances and dielectric heating, there may be significant thermal load on at least portions of the impedance matching network that are provided adjacent to the chamber feed unit.

This thermal load increases the requirements on the components of the impedance matching network regarding thermostability, thereby increasing spatial requirements and the manufacturing costs. In fact, the thermal load may even prevent the use of certain components such as certain types of capacitors.

Thus, the object of the present invention is to provide an impedance matching network, an impedance matching control system, and a method of impedance matching provide an improved handling of thermal load.

According to the invention, the problem is solved by an impedance matching network for plasma processes. The impedance matching network comprises an input port being connectable to a radio frequency, RF, generator module. The impedance matching network further comprises an output port being connectable to a load. The impedance matching network further comprises a transmission circuit, wherein the transmission circuit connects the output port to the input port. The transmission circuit comprises a first transmission line and a second transmission line, wherein the first transmission line is electrically connected to the input port, and wherein the second transmission line is electrically connected to the output port. The impedance matching network further comprises a first impedance matching module, wherein the first impedance matching module is configured to connect at least one reactance to the transmission circuit. The impedance matching network further comprises a coupling element, wherein the first transmission line and the second transmission line are coupled to each other by the coupling element, and wherein the coupling element provides an inductive coupling between the first transmission line and the second transmission line.

Therein and in the following, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry, and/or electronic components such as resistors, capacitors, and/or inductors.

Further, the term "electrically connected" is understood to denote a direct connection via an electrical conductor.

On the other hand, the term "electrically decoupled" used hereinafter is understood to denote that there is no direct electrical connection via an electrical conductor directly connecting the respective components. However, the respective components can still be coupled, e.g. via an inductive coupling. Further, the respective components may be connected to a common reference potential, e.g. a common ground potential.

The impedance matching network according to the present invention is based on the idea to provide two different transmission lines that are coupled to each other by the coupling element, such that no electrical current can flow between the first transmission line and the second transmission line directly. In other words, the first transmission line and the second transmission line may be electrically decoupled from each other.

It has turned out that this allows to remove or relocate certain components of the impedance matching network to a different portion of the transmission circuit that allows for an improved removal of heat from the respective components, as will be described in more detail below.

In fact, this allows to provide cooling for these components, e.g. by coupling these components to a common reference potential, e.g. to a ground potential. This allows to use a larger variety of components, particularly components that are susceptible to thermal load and that can usually not be used high-sided, i.e. at portions of the impedance network having a high voltage relative to the common reference potential or between components.

For example, the impedance matching network according to the present invention allows for incorporating electronic switches such as solid-state switches that selectively couple capacitors to the second signal line. This type of switches has a particularly fast switching time, so that the impedance of the impedance matching network can be adapted in a particularly fast manner. Moreover, this type of switches has a particularly long life time, thereby reducing the maintenance costs for the impedance matching network.

In contrast, impedance matching networks known in the state of the art may only use mechanically variable capacitors, which may have significantly lower tuning speeds, but are less susceptible to thermal load.

Moreover, due to the inductive coupling provided by the coupling element, DC voltages are not coupled from the second transmission line back into the first transmission line. This allows to remove a capacitor that is typically required adjacent to the output in order to block DC voltages.

In general, the first impedance matching module is configured to selectively connect the at least one reactance to the transmission circuit, such that the impedance of the impedance matching network can be adapted by means of the first impedance matching module.

In fact, the first impedance matching module may be configured to connect the at least one reactance to or into the first transmission line.

The coupling element may be or comprise a balun, particularly a voltage balun.

According to an aspect of the present invention, the coupling element comprises a first connection port, a second connection port, a third connection port, and a fourth connection port, wherein the first connection port is connected to the first transmission line, and wherein the second connection port is connected to a common reference potential, e.g. a ground potential. In general, an inductance of the coupling element defines coupling characteristics between the first transmission line and the second transmission line. Accordingly, desired coupling characteristic between the first transmission line and the second transmission line can be obtained by choosing an appropriate inductance of the coupling element.

In an embodiment of the present invention, the impedance matching network further comprises a second impedance matching module, wherein the third connection port is connected to the second transmission line, and wherein the fourth connection port is connected to a common reference potential, particularly a ground potential, via the second impedance matching module, wherein the second impedance matching module comprises at least one reactance that is interconnected between the fourth connection port and the common reference potential, particularly the ground potential. Thus, the second impedance matching module is provided on the side of the coupling elements facing away from the output port being connected to the second transmission line. Accordingly, as the second impedance matching module is connected to the common reference potential, thermal energy can be conducted away from the second impedance matching module to the common reference potential, such as ground.

According to another aspect of the present invention, the second impedance matching module is configured to connect at least one additional reactance between the fourth connection port and the common reference potential. Thus, the impedance of the impedance matching network can be adapted by the second impedance matching module that may selectively connect the at least one additional reactance between the fourth connection port and the common reference potential.

For example, the second impedance matching module may comprise at least one electrical switch, particularly at least one solid-state switch, that may be configured to selectively connect the at least one additional reactance between the fourth connection port and the common reference potential. This way, a particularly fast adaptation of the impedance of the impedance matching network is ensured.

The at least one additional reactance may be a capacitor.

In a further embodiment of the present invention, the at least one additional reactance is arranged in parallel to the at least one reactance.

A further aspect of the present invention provides that the second impedance matching module is in physical contact to a common reference potential surface, particularly a ground surface, such that thermal energy can be exchanged between the second impedance matching module and the common reference potential surface. In other words, the second impedance matching module can be cooled via the common reference potential surface, e.g. via the ground surface, such that the thermal load on the components of the second impedance matching module is further reduced.

The coupling element may comprise an outer conductor portion and an inner conductor portion. The first connection port and the second connection port may be connected to the outer conductor portion, wherein the third connection port and the fourth connection port may be connected to the inner conductor portion. Alternatively, the first connection port and the second connection port are connected to the inner conductor portion, wherein the third connection port and the fourth connection port are connected to the outer conductor portion. Therein, the outer conductor portion and the inner conductor portion may be electrically isolated from each other, i.e. there is no electrical current flowing between the outer conductor portion and the inner conductor portion.

According to an aspect of the present invention, the coupling element comprises at least one permeable element having a relative permeability greater than 1, particularly wherein the at least one permeable element comprises or consists of ferrite. More precisely, the at least one permeable element may have a relative magnetic permeability *µ*_{R} > 1.

Accordingly, the first transmission line and the second transmission line may be magnetically coupled with each other via the permeable element.

In fact, the outer conductor portion and the inner conductor portion described above may be magnetically coupled to each other via the permeable element.

Another aspect of the present invention provides that the coupling element comprises a first wire and a second wire, wherein the first wire and the second wire are twisted, wherein the first connection port and the second connection port are connected to different portions of the first wire, and wherein the third connection port and the fourth connection port are connected to different portions of the second wire.

Accordingly, the first transmission line and the second transmission line are inductively coupled to each other by the twisted wires, wherein the first wire is connected to the first transmission line and the second wire is connected to the second transmission line.

In fact, the first wire and the second wire may be electrically isolated from each other, e.g. by a suitable isolating coating.

Instead of being twisted, it is also conceivable that the first wire and the second wire may be provided on top of each other and/or side by side.

Particularly, the first connection port may be connected to a first end region of the first wire, while the second connection port may be connected to a second end region of the first wire, wherein the first end region faces away from the second end region.

Likewise, the third connection port may be connected to a first end region of the second wire, while the fourth connection port may be connected to a second end region of the second wire, wherein the first end region faces away from the second end region.

According to a variant, the first wire and the second wire may be printed onto a circuit board, respectively. The twisted structure of the first wire and the second wire may be obtained by a layered structure of the circuit board, wherein the first wire and the second wire may alternatingly extend in at least two different layers of the circuit board.

In an embodiment of the present invention, a portion of the second transmission line extending between the coupling element and the output port is free of capacitors. As already described above, such capacitors are required in impedance matching networks in order to block DC voltages, but can be omitted in the impedance matching network according to the present invention, thereby reducing manufacturing and maintenance costs.

The at least one reactance of the first impedance matching module may comprise a capacitance. Accordingly, the first impedance matching module may be configured to selectively connect at least one capacitance to and/or into the transmission circuit, particularly to and/or into the first transmission line.

In fact, the first impedance matching module may comprise at least one electronic switch, particularly at least one solid-state switch, being configured to selectively connect the capacitance to and/or into the transmission circuit, particularly to or into the first transmission line. This way, the impedance of the transmission circuit can be adapted in a particularly fast manner.

In a further embodiment of the present disclosure, the first impedance matching module is configured to connect at least one additional reactance to and/or into the first transmission line, particularly wherein the at least one additional reactance comprises an inductance. In fact, the first impedance matching module may be configured to selectively connect the at least one additional reactance to and/or into the first transmission line.

For example, the first impedance matching module may comprise at least one electronic switch, particularly at least one solid-state switch, being configured to selectively connect the at least one additional reactance to and/or into the first transmission line. This way, the impedance of the transmission circuit can be adapted in a particularly fast manner.

According to the invention, the problem further is solved by an impedance matching control system. The impedance matching control system comprises at least one impedance matching network according to any one of the variants described above, a first measurement module, a second measurement module, and a control module. The first measurement module is configured to receive at least one input signal of the at least one impedance matching network, wherein the first measurement module is configured to determine at least one first measurement parameter based on the at least one input signal. The second measurement module is connected to the output port of the at least one impedance matching network, wherein the second measurement module is configured to determine at least one second measurement parameter based on at least one output signal of the at least one impedance matching network. The control module is configured to control the at least one impedance matching network based on the at least one first measurement parameter and based on the at least one second measurement parameter.

More precisely, the control module may be configured to control the first impedance matching module and/or the second impedance matching module described above.

In fact, the control module may determine an impedance of the impedance matching network based on the at least one first measurement parameter and based on the at least one second measurement parameter. The control module may compare the impedance determined with a target impedance that is to be set. The control module may control the impedance matching network to adapt its impedance based on the comparison.

Regarding the further advantages and properties of the impedance matching control system, reference is made to the explanations given above with respect to the impedance matching network, which also hold for the impedance matching control system and vice versa.

The impedance matching control system may further comprise at least one RF generator module, and at least one chamber feed unit, wherein the at least one chamber feed unit is configured to feed energy into plasma, wherein the input port of the at least one impedance matching network is connected to the at least one RF generator module, and wherein the output port of the at least one impedance matching network is connected to the at least one chamber feed unit. Accordingly, an RF signal generated by the RF generator module is forwarded to the chamber feed unit by the impedance matching network. Impedance matching of a load presented to the RF generator module is provided by the impedance matching network, such that reflection losses of the RF signal are minimized and the energy fed into the plasma is maximized.

According to the present invention, the problem further is solved by a method of impedance matching, particularly for a plasma process. The method comprises the steps of
- receiving at least one input signal;
- forwarding the at least one input signal to at least one impedance matching network, particularly to an impedance matching network according to any one of the variants described above;
- processing, by the at least one impedance matching network, the at least one input signal, thereby obtaining at least one output signal;
- determining, by a first measurement module, at least one first measurement parameter based on the at least one input signal;
- determining, by a second measurement module, at least one second measurement parameter based on the at least one output signal; and
- controlling, by a control module, the at least one impedance matching network to adapt an impedance of the at least one impedance matching network based on the at least one first measurement parameter and based on the at least one second measurement parameter.

Regarding the further advantages and properties of the method of impedance matching, reference is made to the explanations given above with respect to the impedance matching network and the impedance matching control system, which also hold for the method of impedance matching and vice versa.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows an impedance matching control system according to the present invention;
- Figure 2 schematically shows an impedance matching network of the impedance matching control system of Figure 1;
- Figure 3 shows an exemplary embodiment of a coupling element of the impedance matching network of Figure 2;
- Figure 4 shows a further exemplary embodiment of a coupling element of the impedance matching network of Figure 2;
- Figure 5 shows a further exemplary embodiment of a coupling element of the impedance matching network of Figure 2;
- Figure 6 schematically shows an exemplary embodiment of an impedance matching module; and
- Figure 7 shows a flow chart of a method of impedance matching according to the present disclosure.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

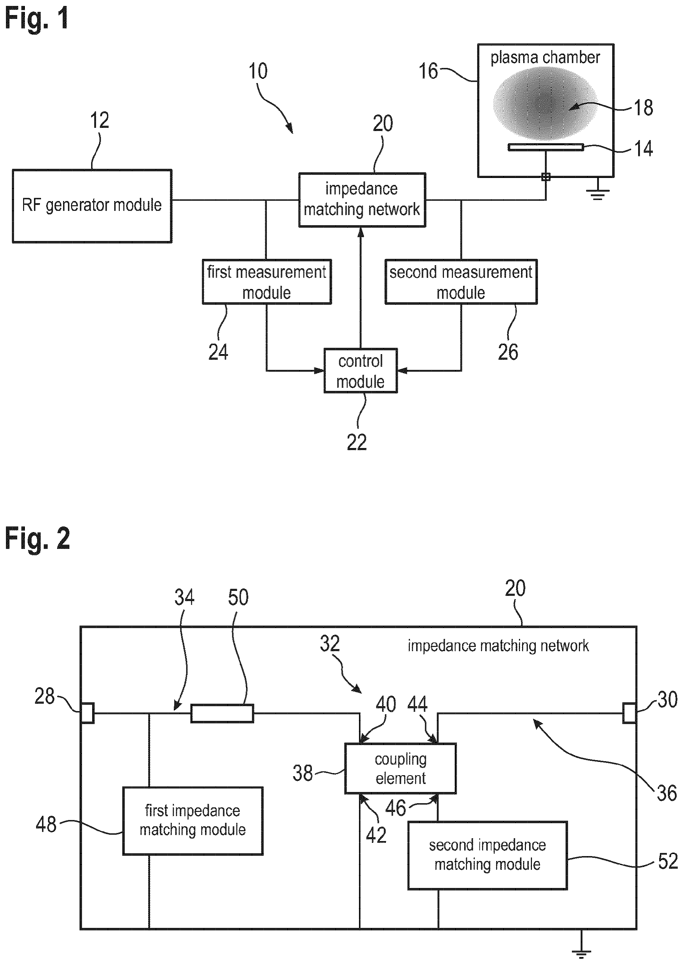

Figure 1 schematically shows an impedance matching control system 10 that comprises an RF generator module 12 and a chamber feed unit 14, wherein the chamber feed unit 14 is located in a plasma chamber 16.

In general, the RF generator module 12 is configured to generate an RF signal that is forwarded to the chamber feed unit 14.

The chamber feed unit 14 feeds the RF signal into plasma 18 contained in the plasma chamber 16, thereby initiating and/or maintaining the plasma 18.

For example, the chamber feed unit 14 may be an electrode.

In order to minimize losses and maximize the amount of energy fed into the plasma 18, the impedance matching control system 10 comprises a impedance matching network 20, wherein an impedance of the impedance matching network 20 can be adapted in order to account for a varying impedance of the plasma 18.

More precisely, the impedance matching network 20 is interconnected between the RF generator module 12 and the chamber feed unit 14, such that the impedance of a load presented to the RF generator module 12 can be adapted by the impedance matching network 20.

As will be described in more detail below, the impedance of the impedance matching network 20 is controlled by a control module 22.

In general, the control module 22 controls the impedance matching network 20 based on at least one first measurement parameter obtained by a first measurement module 24, and based on at least one second measurement parameter obtained by a second measurement module 26.

Therein, the first measurement module 24 receives an input signal of the impedance matching network 20, and determines the at least one first measurement parameter based on the input signal of the impedance matching network 20.

In fact, the input signal of the impedance matching network 20 corresponds to the RF signal generated by the RF generator module 12.

The second measurement module 26 receives an output signal of the impedance matching network 20, and determines the at least one second measurement parameter based on the output signal of the impedance matching network 20.

The output signal of the impedance matching network 20 corresponds to the RF signal generated by the RF generator module 12 and processed by the impedance matching network 20.

Figure 2 schematically shows the impedance matching network 20 in more detail.

The impedance matching network 20 comprises an input port 28 that is connected to the RF generator module 12.

The impedance matching network 20 further comprises an output port 30 that is connected to the chamber feed unit 14.

Between the input port 28 and the output port 30, a transmission circuit 32 is provided that connects the input port 28 to the output port 30.

In general, the transmission circuit 32 forwards the RF signal generated by the RF generator module 12 from the input port 28 to the output port 30 while matching an impedance presented to the RF generator module 12.

The transmission circuit 32 comprises a first transmission line 34 being connected to the input port 28 and to a common reference potential.

For example, the common reference potential may be a ground potential.

The transmission circuit 32 further comprises a second transmission line 36 being connected to the output port 30 and to a common reference potential.

The first transmission line 34 and the second transmission line 36 are inductively coupled to each other by a coupling element 38.

In general, the coupling provided by the coupling element 38 is such that no electrical current flows between the first transmission line 34 and the second transmission line 36 directly.

In fact, the first transmission line 34 and the second transmission line 36 may be electrically decoupled from each other, i.e. electrically separated.

The coupling element 38 comprises a first connection port 40 that is connected to the first transmission line 34, and a second connection port 42 that is connected to the common reference potential.

The coupling element 38 further comprises a third connection port 44 that is connected to the output port 30 via the second transmission line 36.

Moreover, the coupling element 38 comprises a fourth connection port 46 that is connected to the common reference potential.

The impedance matching network 20 further comprises a first impedance matching module 48.

In general, the first impedance matching module 48 is configured to selectively connect at least one reactance to and/or into the first transmission line 34.

The at least one reactance may comprise at least one capacitance and/or at least one inductance.

In fact, the at least one reactance may comprise a plurality of capacitances and/or a plurality of inductances.

The first transmission line 34 may comprise at least one further reactance 50, particularly at least one further inductance, that is provided in the first transmission line 34.

The impedance matching network 20 further comprises a second impedance matching module 52 that is interconnected between the coupling element 38 and the common reference potential, i.e. the second impedance matching module 52 is connected to the fourth connection port 46 of the coupling element 38.

The second impedance matching module 52 is configured to connect at least one reactance to and/or into the second transmission line 36.

The at least one reactance may comprise at least one capacitance and/or at least one inductance.

In fact, the at least one reactance may comprise a plurality of capacitances and/or a plurality of inductances.

Therein, the second impedance matching module 52 may be in physical contact to a common reference potential surface, e.g. a ground surface, corresponding to the common reference potential, such that thermal energy can be exchanged between the second impedance matching module 52 and the common reference potential surface.

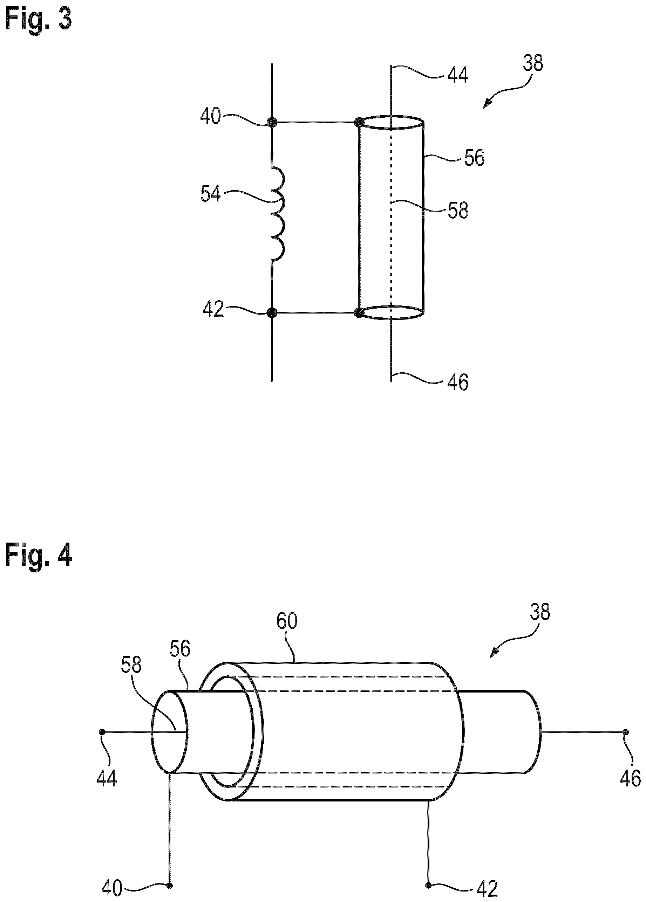

Figure 3 shows an exemplary embodiment of the coupling element 38 in more detail.

In this exemplary embodiment, the coupling element 38 is established as a balun.

In Figure 3, an inductance of the coupling element 38 is indicated by a representative inductor 54.

The coupling element 38 further comprises an outer conductor portion 56 that connects the first connection port 40 to the second connection port 42, as well as an inner conductor portion 58 that connects the third connection port 44 to the fourth connection port 46.

The outer conductor portion 56 at least partially encloses the inner conductor portion 58, wherein the outer conductor portion 56 is electrically isolated from the inner conductor portion 58.

Accordingly, the outer conductor portion 56 and the inner conductor portion may be established similarly to a coaxial cable, particularly as a coaxial cable.

It is noted that instead of the arrangement described above, the first connection port 40 and the second connection port 42 may be connected to the inner conductor portion 58, while the third connection port 44 and the fourth connection port 46 may be connected to the outer conductor portion 56.

Figure 4 shows a further exemplary embodiment of the coupling element 38.

In this exemplary embodiment, the coupling element 38 comprises the outer conductor portion 56 and the inner conductor portion 58 as described above.

The coupling element 38 may further comprise a permeable element 60 having a relative permeability greater than 1. More precisely, the permeable element 60 may have a relative magnetic permeability *µ_{R}* > 1.

Particularly, the at least one permeable element 60 comprises or consists of ferrite or another suitable material.

In the exemplary embodiment shown in Figure 4, the permeable element 60 has a cylindrical shape, more precisely a circular-cylindrical shape.

The permeable element 60 encloses the outer conductor portion 56 and the inner conductor portion 58, wherein the outer conductor portion 56 and the inner conductor portion 58 extend along an axial direction of the permeable element 60.

Accordingly, the first transmission line 34 and the second transmission line 36 may be magnetically coupled with each other via the permeable element 60.

More precisely, the outer conductor portion 56 and the inner conductor portion 58 are magnetically coupled to each other via the permeable element 60.

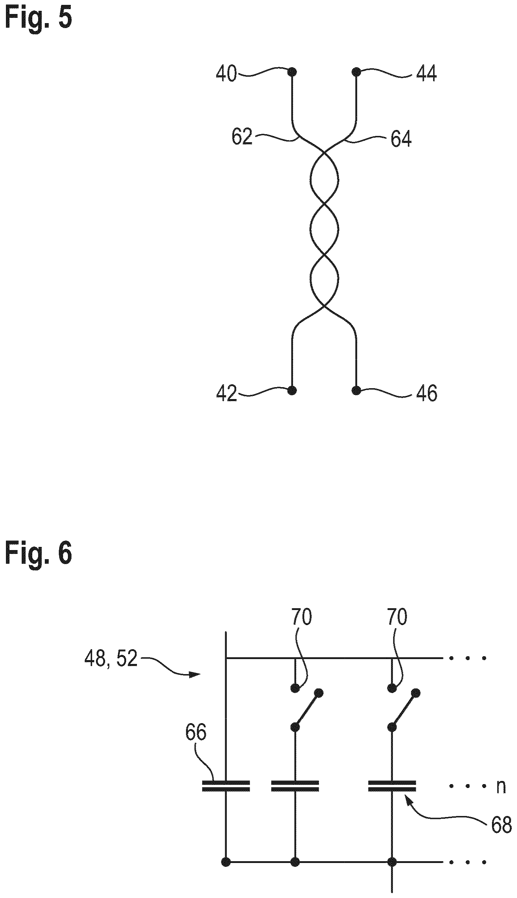

Figure 5 shows a further exemplary embodiment of the coupling element 38.

In this exemplary embodiment, the coupling element comprises a first wire 62 and a second wire 64, wherein the first wire 62 and the second wire 64 are twisted.

Particularly, the first connection port 40 may be connected to a first end the first wire 62, while the second connection port 42 may be connected to a second end of the first wire 62, wherein the first end faces away from the second end.

Further, the third connection port 44 may be connected to a first end the second wire 64, while the fourth connection port 46 may be connected to a second end of the second wire 64, wherein the first end faces away from the second end.

Accordingly, the first transmission line 34 and the second transmission line 36 are inductively coupled to each other by the twisted wires 62, 64, wherein the first wire 62 is connected to the first transmission line 34 and the second wire 64 is connected to the second transmission line 36.

The first wire 62 and the second wire 64 may be printed onto a circuit board, respectively. The twisted structure of the first wire 62 and the second wire 64 may be obtained by a layered structure of the circuit board, wherein the first wire 62 and the second wire 64 may alternatingly extend in at least two different layers of the circuit board.

Moreover, it is also conceivable that the first wire 62 and the second wire 64 may be provided on top of each other and/or side by side.

Figure 6 schematically shows the first impedance matching module 48 in more detail.

The first impedance matching module 48 comprises a first capacitor 66 that is interconnected between the first transmission line 34 and the common reference potential.

In fact, the first capacitor 66 may always be connected to the first transmission line 34, irrespective of a switching state of the first impedance matching module 48 described hereinafter.

The first impedance matching module 48 may comprise a plurality of further capacitors 68 that are arranged in parallel to the first capacitor 66.

The first impedance matching module 48 further comprises a plurality of electronic switches 70 that are configured to selectively connect the further capacitors 68 to the first transmission line 34.

In other words, the electronic switches 70 may connect a single one of the further capacitors 68, a plurality of the further capacitors 68, or all of the further capacitors 68 to the first transmission line 34.

For example, the electronic switches 70 may be established as a solid-state switch, respectively.

In fact, the electronic switches 70 may be or comprise a mechanical switch, a semiconductor switch, a PIN diode, a MOSFET, or other suitable type of electronic circuitry.

It is noted that while the electronic switches 70 are shown to be located closer to the first transmission line than the further capacitors 68, this order could also be reversed.

It is to be understood that instead of or in addition to the capacitors 66, 68, the first impedance matching module 48 may be configured to selectively connect inductors to and/or into the first transmission line 34.

Further, it is to be understood that other topologies are also possible, such as a series connection or a combination of parallel connection and series connection of the respective reactances.

Moreover, it is to be understood that other methods of adjusting the impedance of the first impedance matching module 48 may be used additionally or instead.

For example, one or more of the capacitors 66, 68 may be established as a mechanically variable capacitor whose capacitance can be adjusted by a drive motor.

As another example, the respective capacitance of one or more of the capacitors 66, 68 may be configurable via pulse width modulation (PWM).

In another example, the respective capacitance of one or more of the capacitors 66, 68 may be configurable via phase switched impedance modulation.

The second impedance matching module 52 may be established analogously to the first impedance matching module 48.

Accordingly, the second impedance matching module 52 is configured to selectively connect capacitors and/or inductors between the fourth connection port 46 and the common reference potential.

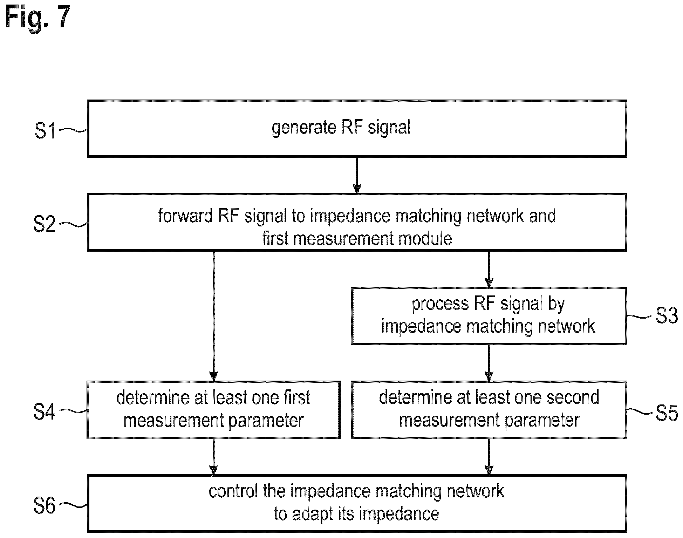

The impedance matching control system 10 described above is configured to perform a method of impedance matching that is described hereinafter with reference to Figure 7.

An RF signal is generated by the RF generator module 12 (step S1).

The RF signal is forwarded to and received by both the impedance matching network 20 and the first measurement module 24 (step S2).

Accordingly, the RF signal generated by the RF generator module 12 is an input signal of the impedance matching network 20.

Therein, the first measurement module 24 may be coupled to a signal path between the RF generator module 12 and the impedance matching network 20 upstream of the impedance matching network 20, for example by a directional coupler.

Alternatively, the first measurement module 24 may be connected to the input port 28 of the impedance matching network 20.

The RF signal generated by the RF generator module 12 is processed by the impedance matching network 20, thereby obtaining an output signal (step S3).

The output signal of the impedance matching network 20 is forwarded to both the chamber feed unit 14 and to the second measurement module 26.

Therein, the second measurement module 26 may be coupled to a signal path between the impedance matching network 20 and the chamber feed unit 14, for example by a directional coupler.

Alternatively, the second measurement module 26 may be connected to the output port 30 of the impedance matching network 20.

At least one first measurement parameter is determined by the first measurement module 24 based on the input signal of the impedance matching network 20, i.e. based on the RF signal generated by the RF generator module 12 (step S4).

For example, the at least one first measurement parameter may comprise an amplitude of the input signal, a phase of the input signal, and/or a power level of the input signal.

Further, at least one second measurement parameter is determined by the second measurement module 26 based on the output signal of the impedance matching network 20, i.e. based on the RF signal processed by the impedance matching network 20 (step S5).

For example, the at least one second measurement parameter may comprise an amplitude of the output signal, a phase of the output signal, and/or a power level of the output signal.

Based on the at least one first measurement parameter and based on the at least one second measurement parameter, the control module 22 controls the impedance matching network 20 to adapt its impedance (step S6).

More precisely, the control module 22 may control the first impedance matching module 48 to adapt the impedance of the transmission circuit 32 by selectively connecting one or more reactances to and/or into the first transmission line 34.

Alternatively or additionally, the control module 22 may control the first impedance matching module 48 to adapt the impedance of the transmission circuit 32 by selectively disconnecting one or more reactances from the first transmission line 34.

Likewise, the control module 22 may control the second impedance matching module 52 two adapt the impedance of the transmission circuit 32 by selectively connecting one or more reactances to and/or into the second transmission line 36, namely between the fourth connection port 46 and the common reference potential.

Alternatively or additionally, the control module 22 may control the second beans matching module 48 to adapt the impedance of the transmission circuit 32 by selectively disconnecting one or more reactances from the second transmission line 36.

Therein, the control module 22 may determine an impedance of the impedance matching network 20 based on the at least one first measurement parameter and based on the at least one second measurement parameter. The control module 22 may compare the impedance determined with a target impedance of the impedance matching network 20 that is to be set. The control module 22 may control the impedance matching network 20 to adapt its impedance based on the comparison as described above.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. An impedance matching network for plasma processes,
wherein the impedance matching network (20) comprises an input port (28) being connectable to a radio frequency, RF, generator module (12),
wherein the impedance matching network (20) further comprises an output port (30) being connectable to a load,
wherein the impedance matching network (20) further comprises a transmission circuit (32), wherein the transmission circuit (32) connects the output port (30) to the input port (28), wherein the transmission circuit (32) comprises a first transmission line (34) and a second transmission line (36), wherein the first transmission line (34) is electrically connected to the input port (28), wherein the second transmission line (36) is electrically connected to the output port (30),
wherein the impedance matching network (20) further comprises a first impedance matching module (48), wherein the first impedance matching module (48) is configured to connect at least one reactance to the transmission circuit (32), and
wherein the impedance matching network (20) further comprises a coupling element (38), wherein the first transmission line (34) and the second transmission line (36) are coupled to each other by the coupling element (38), and wherein the coupling element (38) provides an inductive coupling between the first transmission line (34) and the second transmission line (36).

2. The impedance matching network of claim 1, wherein the coupling element (38) comprises a first connection port (40), a second connection port (42), a third connection port (44), and a fourth connection port (46), wherein the first connection port (40) is connected to the first transmission line (34), and wherein the second connection port (42) is connected to a common reference potential, e.g. a ground potential.

3. The impedance matching network of claim 2, wherein the impedance matching network (20) further comprises a second impedance matching module (52), wherein the third connection port (44) is connected to the second transmission line (36), and wherein the fourth connection port (46) is connected to the common reference potential, particularly the ground potential, via the second impedance matching module (52), wherein the second impedance matching module (52) comprises at least one reactance that is interconnected between the fourth connection port and the common reference potential, particularly the ground potential,.

4. The impedance matching network of claim 3, wherein the second impedance matching module (52) is configured to connect at least one additional reactance between the fourth connection port (46) and the reference potential.

5. The impedance matching network of claim 4, wherein the at least one additional reactance is arranged in parallel to the at least one reactance.

6. The impedance matching network according to any one of claims 3 to 5, wherein the second impedance matching module (52) is in physical contact to a reference potential surface, particularly a ground surface, such that thermal energy can be exchanged between the second impedance matching module (52) and the reference potential surface.

7. The impedance matching network according to any one of claims 2 to 6, wherein the coupling element (38) comprises an outer conductor portion (56) and an inner conductor portion (58),
wherein the first connection port (40) and the second connection port (42) are connected to the outer conductor portion (56), wherein the third connection port (44) and the fourth connection port (46) are connected to the inner conductor portion (58), or
wherein the first connection port (40) and the second connection port (42) are connected to the inner conductor portion (58), wherein the third connection port (44) and the fourth connection port (46) are connected to the outer conductor portion (56).

8. The impedance matching network according to any one of the preceding claims, wherein the coupling element (38) comprises at least one permeable element (60) having a relative permeability greater than 1, particularly wherein the at least one permeable element comprises or consists of ferrite.

9. The impedance matching network according to any one of the preceding claims, wherein the coupling element (38) comprises a first wire (62) and a second wire (64), wherein the first wire (62) and the second wire (64) are twisted, wherein the first connection port (40) and the second connection port (42) are connected to different portions of the first wire (62), and wherein the third connection port (44) and the fourth connection port (46) are connected to different portions of the second wire (64).

10. The impedance matching network according to any one of the preceding claims, wherein a portion of the second transmission line (36) extending between the coupling element (38) and the output port (30) is free of capacitors.

11. The impedance matching network according to any one of the preceding claims, wherein the at least one reactance of the first impedance matching module (48) comprises a capacitance.

12. The impedance matching network according to any one of the preceding claims, wherein the first impedance matching module (48) is configured to connect at least one additional reactance to and/or into the first transmission line (34), particularly wherein the at least one additional reactance comprises an inductance.

13. An impedance matching control system, wherein the impedance matching control system (10) comprises at least one impedance matching network (20) according to any one of the preceding claims, a first measurement module (24), a second measurement module (26), and a control module (22),
wherein the first measurement module (24) is configured to receive at least one input signal of the at least one impedance matching network (20), wherein the first measurement module (24) is configured to determine at least one first measurement parameter based on the at least one input signal,
wherein the second measurement module (26) is connected to the output port (30) of the at least one impedance matching network (20), wherein the second measurement module (26) is configured to determine at least one second measurement parameter based on at least one output signal of the at least one impedance matching network (20), and
wherein the control module (22) is configured to control the at least one impedance matching network (20) based on the at least one first measurement parameter and based on the at least one second measurement parameter.

14. The impedance matching control system of claim 13, further comprising at least one RF generator module (12), and at least one chamber feed unit (14), wherein the at least one chamber feed unit (14) is configured to feed energy into plasma (18), wherein the input port (28) of the at least one impedance matching network (20) is connected to the at least one RF generator module (12), and wherein the output port (30) of the at least one impedance matching network (20) is connected to the at least one chamber feed unit (14).

15. A method of impedance matching, particularly for a plasma process, the method comprising the steps of
- receiving at least one input signal;
- forwarding the at least one input signal to at least one impedance matching network (20), particularly to an impedance matching network (20) according to any one of claims 1 to 12;
- processing, by the at least one impedance matching network (20), the at least one input signal, thereby obtaining at least one output signal;
- determining, by a first measurement module (24), at least one first measurement parameter based on the at least one input signal;
- determining, by a second measurement module (26), at least one second measurement parameter based on the at least one output signal; and
- controlling, by a control module (22), the at least one impedance matching network (20) to adapt an impedance of the at least one impedance matching network (20) based on the at least one first measurement parameter and based on the at least one second measurement parameter.
